# EUROPÄISCHE PATENTSCHRIFT

(11) **EP 2 422 165 B1**
(45) Veröffentlichungstag und Bekanntmachung des Hinweises auf die Patenterteilung: **04.05.2016**
(21) Anmeldenummer: 10704754.0
(22) Anmeldetag: 10.02.2010
(51) Int. Cl.: G01D 7/00

(54) **MESSGERÄT UND MESSVERFAHREN MIT DYNAMISCHER KANALZUWEISUNG**
MEASURING INSTRUMENT AND MEASURING METHOD FEATURING DYNAMIC CHANNEL ALLOCATION
APPAREIL DE MESURE ET PROCEDE DE MESURE AVEC AFFECTATION DYNAMIQUE DES CANAUX

(30) Priorität: 24.04.2009 DE 102009018778
(43) Veröffentlichungstag der Anmeldung: 29.02.2012
(73) Patentinhaber: Rohde & Schwarz GmbH & Co. KG, 81671 München (DE)
(72) Erfinder: FRANZ, Stefan, 81379 München (DE); LEIBFRITZ, Martin, 81825 München (DE)
(74) Vertreter: Körfer, Thomas
(86) Internationale Anmeldenummer: PCT/EP2010/000810
(87) Internationale Veröffentlichungsnummer: WO 2010/121681

(56) Entgegenhaltungen:
- DE-A1-102006 023 914
- US-A- 5 321 420
- US-B1- 6 271 654

## Beschreibung

Die Erfindung betrifft ein Messgerät dessen Messkanäle dynamisch seinen Anschlüssen zugewiesen werden und ein entsprechendes Messverfahren.

Zur Bestimmung der Streuparameter eines Messobjekts wird herkömmlicherweise ein Vektor-Netzwerk-Analysator herangezogen. Bei einem solchen Messgerät sind die Anschlüsse für die Messsignale üblicherweise den Messkanälen fest zugeordnet. Die Zuordnung ist durch eine Beschriftung an den Anschlüssen an dem Gehäuse des Messgeräts kenntlich gemacht.

Nachteilhaft an dieser festen Zuordnung ist jedoch, dass ein Benutzer des Messgeräts eine durchzuführende Messaufgabe an die Zuordnung anpassen muss. D.h. er muss eine u.U. aufwändigere Verkabelung in Kauf nehmen, um die Messaufgabe durchführen zu können. Alternativ ist er gezwungen, die bestimmten Streuparameter in eine gewünschte Form umzurechnen.

Zum technischen Hintergrund zeigt die DE 10 2006 023 914 A1 ein Oszilloskop mit einer festen Zuordnung der Anschlüsse zu Messkanälen mit einer Vorschau-Darstellung.

Der Erfindung liegt die Aufgabe zu Grunde, ein Messgerät und ein Messverfahren zu schaffen, welche eine große Flexibilität des Anschlusses des Messobjekts ermöglichen, ohne aufwendige nachträgliche Rechnungen zu erfordern.

Die Aufgabe wird erfindungsgemäß für die Vorrichtung durch die Merkmale des unabhängigen Anspruchs 1 und für das Verfahren durch die Merkmale des unabhängigen Anspruchs 4 gelöst. Vorteilhafte Weiterbildungen sind Gegenstand der hierauf rückbezogenen Unteransprüche.

Ein erfindungsgemäßes Messgerät verfügt über eine Steuerungseinrichtung, zumindest zwei Anschlüsse, zumindest zwei Messkanäle und zumindest zwei Anzeigeeinrichtungen. Die Steuerungseinrichtung weist den Messkanälen Anschlüsse zu und verbindet die Messkanäle intern zumindest logisch mit diesen Anschlüssen. Jedem Anschluss ist dabei eine Anzeigeeinrichtung zugeordnet. Die den Anschlüssen zugeordneten Anzeigeeinrichtungen zeigen Informationen, die gegenwärtige Zuweisung und/oder Nutzung der jeweiligen Anschlüsse betreffend an. So ist ein sehr einfacher Anschluss eines Messobjekts möglich.

Der jeweilige Anschluss und die zugeordnete Anzeigeeinrichtung befinden sich bevorzugt in großer räumlicher Nähe. So ist eine einfache Zuordnung der jeweiligen Anzeigeeinrichtung zu dem Anschluss für den Benutzer gewährleistet. Eine einfache Bedienung wird so erreicht.

Zumindest zwei Anzeigeeinrichtungen sind bevorzugt zu einer Anzeigeeinheit zusammengefasst. Die Anzeigeeinheit ist bevorzugt zumindest zwei Anschlüssen zugeordnet. So wird der Aufwand der Herstellung des Messgeräts reduziert.

Vorteilhafterweise zeigen die Anzeigeeinrichtungen Informationen durch farbliche Codierung und/oder durch Muster an. So wird die intuitive Bedienbarkeit weiter erleichtert.

Die Anzeigeeinrichtungen sind jeweils ringförmig um die zugeordneten Anschlüsse ausgebildet. So wird eine sehr gute Zuordnung der Anzeigeeinrichtungen zu den Anschlüssen erreicht.

Die von den Anzeigeeinrichtungen angezeigten Informationen zeigen vorteilhafterweise den zugeordneten Anschlüssen zugewiesene Messkanäle des Messgeräts an. So wird die Zuordnung der Messkanäle und Anschlüsse deutlich sichtbar.

Die von den Anzeigeeinrichtungen angezeigten Informationen betreffen bevorzugt Kalibrierungen der zugeordneten Anschlüsse. Vorteilhafterweise zeigen die von den Anzeigeeinrichtungen angezeigten Informationen erfolgte Kalibrierungen der zugeordneten Anschlüsse und/oder Arten der erfolgten Kalibrierungen an. So kann ein Benutzer mit geringem Aufwand erkennen, ob eine für eine bestimmte Messung notwendige Kalibrierung bereits vorliegt.

Bevorzugt charakterisieren die von den Anzeigeeinrichtungen angezeigten Informationen mittels der Anschlüsse ausgegebene Signale. Die von den Anzeigeeinrichtungen angezeigten Informationen zeigen vorteilhafterweise Frequenzen und/oder Leistungen mittels der Anschlüsse ausgegebener Signale an. So ist ein übersichtlicher und einfacher Anschluss eines Messobjekts gewährleistet.

Nachfolgend wird die Anmeldung anhand der Zeichnungen, in welchen vorteilhafte Beispiele der Anmeldung dargestellt werden, beispielhaft beschrieben. In den Zeichnungen zeigen:
- Fig. 1: ein Blockschaltbild eines in Verbindung mit der Erfindung benutzbaren Netzwerkanalysators;
- Fig. 2: ein Beispiel eines Blockschaltbilds des Messgeräts;
- Fig. 3: ein erstes Beispiel der Anzeige des Messgeräts;
- Fig. 4: ein zweites Beispiel der Anzeige des Messgeräts;
- Fig. 5: ein Ausführungsbeispiel der Anzeige des erfindungsgemäßen Messgeräts, und
- Fig. 6: ein Beispiel des Ablaufdiagramms des Messverfahrens.

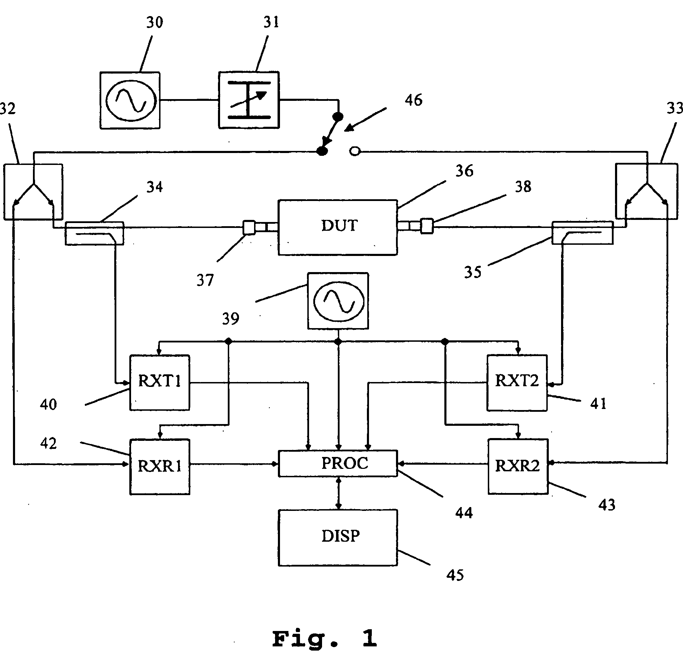

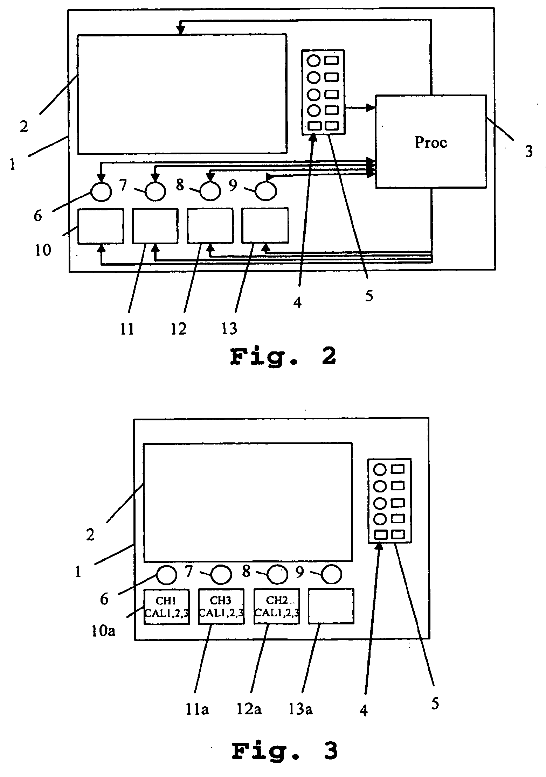

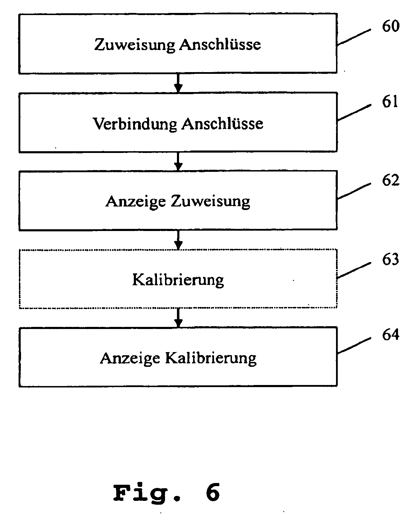

Zunächst werden anhand der Figur 1 der Aufbau und die Funktionsweise eines beispielshaften Messgeräts gezeigt. Anschließend wird mittels der Figur 2 ein Beispiel des Messgeräts erläutert. Mittels der Figuren 3 bis 5 wird anhand mehrerer Ausführungsbeispiele des Messgeräts der Aufbau und die Funktionsweise verschiedener Anzeigeeinrichtungen veranschaulicht. Abschließend wird anhand der Figur 6 die Funktionsweise eines Ausführungsbeispiels des erfindungsgemäßen Messverfahrens dargestellt. Identische Elemente wurden in ähnlichen Abbildungen zum Teil nicht wiederholt dargestellt und beschrieben.

In Fig. 1 wird ein Blockschaltbild eines in Verbindung mit der Erfindung benutzbaren Netzwerkanalysators dargestellt.

Das hier dargestellte beispielhafte Messgerät ist ein Vektor-Netzwerk-Analysator. Ein Signalgenerator 30 ist mit einer Pegelveränderungseinrichtung 31 verbunden. Die Pegelveränderungseinrichtung 31 ist mit einem Schalter 46 verbunden. Der Schalter 46 ist mit einem ersten Signalverteiler 32 und einem zweiten Signalverteiler 33 verbunden. Die Signalverteiler 32, 33 sind jeweils mit. einem Richtkoppler 34, 35 und einem Referenzempfänger 42, 43 verbunden. Die Richtkoppler 34, 35 sind jeweils mit einem Anschluss 37, 38 verbunden. Mittels der Anschlüsse 37, 38 ist ein Messobjekt 36 angeschlossen. Mit den Richtkopplern 34, 35 sind weiterhin die Messempfänger 40, 41 verbunden. Ein Lokaloszillator 39 ist mit den Messempfängern 40, 41 und den Referenzempfängern 42, 43 verbunden. Die Messempfänger 40, 41 und die Referenzempfänger 42, 43 sind mit einer Verarbeitungseinrichtung 44 verbunden. Die Verarbeitungseinrichtung 44 ist weiterhin mit einer Anzeigeeinrichtung 45 verbunden.

Um eine Messung mit dem Vektor-Netzwerk-Analysator durchzuführen, muss zunächst eine Kalibrierung durchgeführt werden. Hierzu werden nacheinander anstatt des Messobjekts 36 mehrere Kalibrierstandards abgeschlossen. Während jeweils ein Kalibrierstandard angeschlossen ist, wird eine Kalibriermessung durchgeführt. Dabei beaufschlagt der Signalgenerator 30 den Kalibrierstandard mit einem Signal. Das von dem Signalgenerator 30 erzeugte Signal wird von der Pegelveränderungseinrichtung 31 in seinem Pegel angepasst. Der Schalter 46 leitet das Signal über einen der Signalverteiler 32, 33 und einen der Richtkoppler 34, 35 zu einem der Anschlüsse 37, 38, an welchem der Kalibrierstandard angeschlossen ist. In dem hier dargestellten Beispiel wird das von dem Signalgenerator 30 bereitgestellte Signal von dem Schalter 46 an den Signalverteiler 32 und über den Richtkoppler 34 zu dem Anschluss 37 übertragen. Ein Teil des Signals wird von dem Kalibrierstandard reflektiert und von dem Richtkoppler 34 an den Messempfänger 40 übertragen. Sofern es sich bei dem Kalibrierstandard um einen transmissiven Kalibrierstandard handelt, wird ein Teil des Messsignals an dem Anschluss 38 ausgegeben und von dem Richtkoppler 35 an den Messempfänger 41 übertragen. Die Messempfänger 40, 41 werden von dem Lokaloszillator 39 mit einem Referenzsignal beaufschlagt. Die Messempfänger 40, 41 mischen das jeweils empfangene Messsignal mit dem Referenzsignal, digitalisieren dieses und leiten es an die Verarbeitungseinrichtung 44 weiter.

Das von dem Signalgenerator 30 erzeugte Signal wird weiterhin von dem Signalverteiler 32 an den Referenzempfänger 42 geleitet. Auch der Referenzempfänger 42 empfängt ein Referenzsignal von dem Lokaloszillator 39. Wie auch die Messempfänger 40, 41 mischt der Referenzempfänger 42 das Referenzsignal mit dem Messsignal und digitalisiert das resultierende Signal. Er leitet es ebenfalls an die Verarbeitungseinrichtung 44 weiter.

Im Fall der hier dargestellten Zweitor-Kalibrierung wird die Messung für jeden Kalibrierstandard für beide Signalrichtungen, d.h. beide Schalterstellungen des Schalters 46 wiederholt. Diese Messungen werden weiterhin für mehrere Kalibrierstandards wiederholt. Anhand der Kalibriermessungen wird eine Kalibrierung des Vektor-Netzwerk-Analysators durchgeführt.

Der hier dargestellte Vektor-Netzwerk-Analysator verfügt lediglich über zwei Tore, welche den beiden Anschlüssen 37, 38 entsprechen. Wird eine Kalibrierung unter Verwendung eines transmissiven Kalibrierstandards durchgeführt, so sind die beiden Tore des Vektor-NetzwerkAnalysators miteinander kalibriert. D.h. Messungen an transmissiven Messobjekten sind mit sehr geringem Fehler möglich. Wurde lediglich eine Kalibrierung anhand nichttransmissiver Kalibrierstandards (Eintor-Kalibrierung) durchgeführt, so sind die Tore des Vektor-NetzwerkAnalysators nicht miteinander kalibriert. Lediglich Messungen an reflexiven Messobjekten können mit geringem Fehler durchgeführt werden. Es ist in diesem Fall jedoch auch keine Wiederholung von Messungen mit unterschiedlichen Signalrichtungen notwendig.

Sollen bei einem Netzwerkanalysator mit einer größeren Anzahl von Messtoren z.B. 4 Messtore vollständig kalibriert werden, so genügt eine Wiederholung der Messungen für zwei Signalrichtungen nicht. Vielmehr müssen sämtliche mögliche Signalrichtungen zwischen den Messtoren kalibriert werden. Ein Anwendungsfall mit mehr als zwei eingesetzten Messtoren wird anhand von Fig. 3 näher beschrieben.

Die Messung an einem Messobjekt 36 erfolgt analog der dargestellten Kalibriermessung. Die ermittelten Messergebnisse werden anhand einer Korrekturrechnung korrigiert. Für diese Korrekturrechnung werden die Ergebnisse der Kalibriermessungen herangezogen. Die Ergebnisse der Korrekturrechnung werden von der Verarbeitungseinrichtung 44 auf der Anzeigeeinrichtung 45 dargestellt.

Es sind Messgeräte beliebiger Anzahl an Messtoren einsetzbar.

Fig. 2 zeigt ein Blockschaltbild eines Beispiels des Messgeräts. Ein Gehäuse 1 beinhaltet eine erste Anzeigeeinrichtung 2, eine Verarbeitungseinrichtung 3, mehrere Anschlüsse 6, 7, 8, 9 und mehrere zweite Anzeigeeinrichtungen 10, 11, 12, 13. Weiterhin beinhaltet das Gehäuse 1 eine Eingabeeinrichtung 5 mit mehreren Bedienelementen 4. Die Verarbeitungseinrichtung 3 ist dabei mit der ersten Anzeigeeinrichtung 2, den zweiten Anzeigeeinrichtungen 10 bis 13, der Eingabeeinrichtung 5 und den Anschlüssen 6 bis 9 verbunden.

Über zumindest einen der Anschlüsse 6 bis 9 wird ein Messobjekt an das Messgerät angeschlossen. Die Verarbeitungseinrichtung 3 weist den einzelnen Anschlüssen 6 bis 9 Messkanäle zu. Die Zuweisung der Messkanäle wird dabei optional von der Verarbeitungseinrichtung 3 auf den zweiten Anzeigeeinrichtungen 10 bis 13 dargestellt. Die Verarbeitungseinrichtung 3 steuert weiterhin den Ablauf der Messung. Über die Eingabeeinrichtung 5 gibt ein Benutzer Informationen die Messung betreffend, z. B. die Art der durchzuführenden Messung, ein. Die Verarbeitungseinrichtung 3 stellt Ergebnisse der Messung auf der ersten Anzeigeeinrichtung 2 dar. Anhand der Fig. 2 bis 4 wird näher auf die Informationen, welche auf den zweiten Anzeigeeinrichtungen 10 bis 13 dargestellt werden, eingegangen.

Fig. 3 zeigt ein erstes Beispiel der Anzeige des Messgeräts. Die Darstellung entspricht weitgehend der Darstellung aus Fig. 2. Hier ist jedoch nur eine vordere Ansicht des erfindungsgemäßen Messgeräts dargestellt. Die Verarbeitungseinrichtung 3 aus Fig. 1 befindet sich im Inneren des erfindungsgemäßen Messgeräts und wird somit hier nicht dargestellt. Auch die Verbindungen der einzelnen Elemente erfolgen rückseitig und sind hier nicht dargestellt.

Bei der hier dargestellten Messaufgabe wird dem Anschluss 6 ein erster Messkanal zugewiesen. Dem Anschluss 7 wird ein dritter Messkanal zugewiesen. Dem Anschluss 8 wird ein zweiter Messkanal zugewiesen. Die Anzeigeeinrichtung 10a ist dem ersten Anschluss 6 zugewiesen. Die Anzeigeeinrichtung 11a ist dem zweiten Anschluss 7 zugewiesen. Die Anzeigeeinrichtung 12a ist dem dritten Anschluss 8 zugewiesen. Die Zuweisung der Kanäle der jeweiligen Anschlüsse wird auf der jeweils zugeordneten Anzeigeeinrichtung dargestellt. So zeigt die erste Anzeigeeinrichtung 10a die Abkürzung CH1, während die zweite Anzeigeeinrichtung 11a die Abkürzung CH3 anzeigt. Die dritte Anzeigeeinrichtung 12a zeigt die Abkürzung CH2. Ergeben sich für den Benutzer des Messgeräts Schwierigkeiten beim Anschluss der Kabel an die Anschlüsse 6, 7, 8, so kann er mit geringem Aufwand eine Neuzuweisung der Kanäle zu anderen Anschlüssen vornehmen.

Die Anzeigeeinrichtungen 10a, 11a, 12a zeigen weiterhin einen Kalibrierstatus an. So wurde eine Kalibrierung der Anschlüsse 6, 7 und 8 jeweils mit sämtlichen anderen zugewiesenen Anschlüssen 6, 7 und 8 durchgeführt. Somit wird von den Anzeigeeinrichtungen die Abkürzung CAL1, 2, 3 angezeigt. Wäre eine Kalibrierung aller vier Anschlüsse durchgeführt worden, so würde eine Abkürzung CAL1-4 in sämtlichen Anzeigeeinrichtungen 10a, 11a, 12a, 13a angezeigt. Wäre lediglich eine Eintorkalibrierung durchgeführt worden, so könnten die Abkürzungen CAL1, CAL2 oder CAL3 lauten. Alternativ oder zusätzlich ist eine Anzeige der Richtung der durchgeführten Kalibrierung möglich. So könnte z.B. eine Abkürzung CAL21 eine Kalibrierung nur in Vorwärtsrichtung anzeigen. Auch eine Anzeige der Art der durchgeführten Kalibrierung, d.h. eine Anzeige der Art der eingesetzten Kalibrierstandards und/oder des Kalibrierverfahrens, ist möglich.

Einmal durchgeführte Kalibrierungen für die verschiedenen Anschlüsse und Zuweisungen werden von der Verarbeitungseinrichtung 3 aus Fig. 1 gespeichert. wird ein Anschluss bzw. eine Kombination von Anschlüssen erneut eingesetzt, so wird die gespeicherte Kalibrierung herangezogen, sofern keine neue Kalibrierung durchgeführt werden soll.

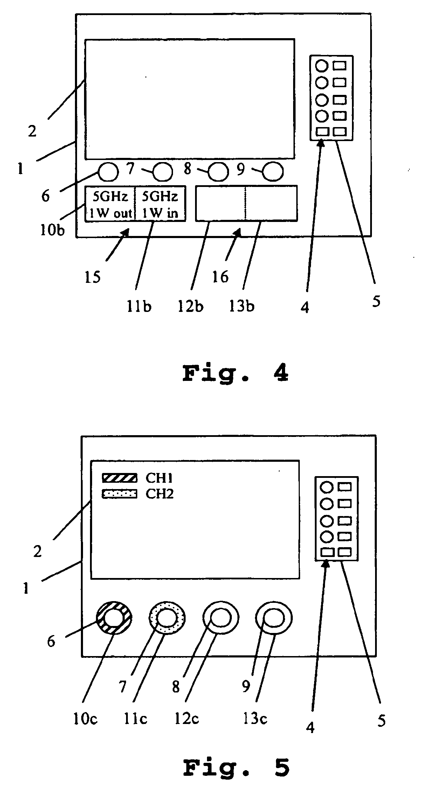

Fig. 4 zeigt ein zweites Beispiel der Anzeige des Messgeräts. Auch diese Darstellung entspricht weitgehend den Darstellungen aus Fig. 2 und Fig. 3. Die Anzeigeeinrichtungen 10b, 11b sind hier jedoch zu einer gemeinsamen Anzeigeeinheit 15 zusammengefasst. Ebenso sind die Anzeigeeinrichtungen 12b und 13b zu einer gemeinsamen Anzeigeeinheit 16 zusammengefasst. So kann das Messgerät unter Verwendung einer geringeren Anzahl an unabhängigen Anzeigeeinrichtungen aufgebaut werden. Der Aufwand der Herstellung kann damit reduziert werden.

Mittels der Anzeigeeinrichtungen 10b, 11b wird hier im Gegensatz zu Fig. 2 nicht die Zuweisung der Kanäle und der Kalibrierstatus angezeigt, sondern die Funktion der jeweiligen Anschlüsse 6, 7. So dient der Anschluss 6 in diesem Ausführungsbeispiel der Ausgabe eines Messsignals mit einer Frequenz von 5 GHz bei einer Ausgangsleistung von 1W. Der Anschluss 7 dient in diesem Beispiel der Messung eines Messsignals einer Frequenz von 5 GHz mit einer maximal erlaubten Empfangsleistung von 1W. Alternativ kann die aktuell gemessene Leistung angezeigt werden. Durch diese Anzeigen ist eine einfache und übersichtliche Anschließbarkeit des Messobjekts gewährleistet. Auch eine Verknüpfung von zwei Ports auf Sendeseite und/oder auf Empfangsseite bei einer differentiellen Messung kann auf den Anzeigeeinrichtungen 6, 7, 8, 9 dargestellt werden. Ein Frequenzbereich eines ausgegebenen Sweep-Signals oder ein von einem Anschluss gemessener Frequenzbereich können dargestellt werden. Darüber hinaus können die Anzeigeeinrichtungen zur Darstellung einer von dem jeweiligen Anschluss ausgegebenen oder gemessenen Spannung oder eines entsprechenden Stroms herangezogen werden, z.B. wenn der Netzwerkanalysator mit Bias-T betrieben wird.

Fig. 5 zeigt ein Ausführungsbeispiel der Anzeige des erfindungsgemäßen Messgeräts. Auch diese Darstellung entspricht in weiten Teilen den Darstellungen aus Fig. 2 bis 4. Die Anzeigeeinrichtungen 10c bis 13c unterscheiden sich hier jedoch deutlich von den Anzeigeeinrichtungen aus Fig. 2 bis 4. So bestehen die Anzeigeeinrichtungen 10c bis 13c aus ringförmigen Strukturen, welche direkt um die Anschlüsse 6 bis 9 angeordnet sind. Die Anzeigeeinrichtungen 10c bis 13c sind in der Lage, jeweils eine Farbe und/oder ein Muster darzustellen. Erst mittels der Anzeigeeinrichtung 2 kann die Zuordnung direkt erkannt werden. So wird auf der Anzeigeeinrichtung 2 eine Legende der Farben bzw. Muster der Anzeigeeinrichtungen 10c bis 13c mit ihrer jeweiligen Bedeutung dargestellt. Alternativ ist eine Darstellung eventueller Messkurven und Signale in der Farbe bzw. mit dem Muster der Anzeigeeinrichtungen 10c bis 13c auf der Anzeigeeinrichtung 2 denkbar. D.h. die Anzeigeeinrichtungen 10c bis 13c zeigen jeweils eine Farbe und/oder ein Muster an, welches ebenfalls zur Darstellung eines über den entsprechenden Anschluss 6 bis 9 gemessenen oder ausgegebenen Signals auf der Anzeigeeinrichtung 2 genutzt wird.

Fig. 6 zeigt ein Beispiel des Messverfahrens. Ausgehend von einem beliebigen Kalibrierstatus des Messgeräts erfolgt in einem ersten Schritt 60 die Zuweisung der eingesetzten Anschlüsse zu Messkanälen des Messgeräts. Dabei wird die notwendige Reihenfolge der Anschlüsse zur Erreichung einer Streumatrix des Messobjekts als Ergebnis der Messung berücksichtigt. In einem zweiten Schritt 61 werden die Anschlüsse mit den zugeordneten Messkanälen des Messgeräts zumindest logisch verbunden. Die Verbindung kann dabei physisch durch Schalter erfolgen. Alternativ erfolgt die Verbindung in Software. D.h. es wird festgelegt, welche Messkanäle bzw. Referenzkanäle ausgelesen und angezeigt werden.

Die Zuweisung der Anschlüsse zu den Messkanälen wird in einem dritten Schritt 62 mittels Anzeigeeinrichtungen, welche in unmittelbarer Umgebung der Anschlüsse angeordnet sind, angezeigt.

Wurde für die ausgewählte Zuweisung der Anschlüsse zu den Messkanälen eine benötigte Kalibrierung, z. B. eine transmissive Kalibrierung, noch nicht durchgeführt, so wird dies in einem optionalen vierten Schritt 63 nachgeholt. So wird durch Anschließen eines oder mehrerer Kalibrierstandards an die Anschlüsse eine Kalibriermessung ermöglicht. Vorzugsweise werden nacheinander mehrere Kalibriermessungen an unterschiedlichen Kalibrierstandards durchgeführt. Eine Anzeige der jeweils anzuschließenden Kalibrierstandards auf den Anzeigeeinrichtungen ist hierbei ebenfalls möglich.

In einem fünften Schritt 64 wird der Kalibrierstatus der Anschlüsse mittels der in der Nähe der Anschlüsse angeordneten Anzeigeeinrichtungen dargestellt. So ist eine Darstellung der erfolgten Kalibrierung eines Anschlusses, wie auch die Darstellung der Art der erfolgten Kalibrierung, möglich. Ist beispielsweise eine transmissive Kalibrierung der Anschlüsse 1 und 2 erfolgt, so würde auf den beiden Anzeigeeinrichtungen die Abkürzung CAL1,2 dargestellt werden.

## Patentansprüche

1. Messgerät mit einer Steuerungseinrichtung (3), zumindest zwei Anschlüssen (6, 7, 8, 9), zumindest zwei Messkanälen,
wobei die Steuerungseinrichtung (3) den Messkanälen Anschlüsse (6, 7, 8, 9) zuweist und die Messkanäle mit diesen Anschlüssen (6, 7, 8, 9) intern zumindest logisch verbindet,
**dadurch gekennzeichnet,**
**dass** das Messgerät weiterhin zumindest zwei Anzeigeeinrichtungen (10c, 11c, 12c, 13c) aufweist,
**dass** jedem Anschluss (6, 7, 8, 9) genau eine Anzeigeeinrichtung (10c, 11c, 12c, 13c) zugeordnet ist, dass die den Anschlüssen (6, 7, 8, 9) zugeordneten Anzeigeeinrichtungen (10c, 11c, 12c, 13c) Informationen, die gegenwärtige Zuweisung und/oder Nutzung der jeweiligen Anschlüsse (6, 7, 8, 9) betreffend anzeigen und
**dass** die Anzeigeeinrichtungen (10c, 11c, 12c, 13c) jeweils ringförmig um die zugeordneten Anschlüsse (6, 7, 8, 9) ausgebildet sind.

2. Messgerät nach Anspruch 1,
**dadurch gekennzeichnet,**
**dass** sich der jeweilige Anschluss (6, 7, 8, 9) und die zugeordnete Anzeigeeinrichtung (10c, 11c, 12c, 13c) in unmittelbarer räumlicher Nähe befinden.

3. Messgerät nach einem der Ansprüche 1 bis 2,
**dadurch gekennzeichnet,**
**dass** die Anzeigeeinrichtungen (10c, 11c, 12c, 13c) Informationen durch farbliche Codierung und/oder durch Muster anzeigen.

4. Messverfahren unter Verwendung eines Messgeräts mit zumindest zwei Anschlüssen (6, 7, 8, 9) und zumindest zwei Messkanälen,
wobei die folgenden Schritte durchgeführt werden:
- Zuweisen von Anschlüssen zu Messkanälen;
- internes zumindest logisches Verbinden der Anschlüsse und der zugewiesenen Messkanäle,
**dadurch gekennzeichnet,**
**dass** das Messgerät weiterhin über zumindest zwei Anzeigeeinrichtungen (10c, 11c, 12c, 13c) verfügt,
**dass** jedem Anschluss (6, 7, 8, 9) genau eine Anzeigeeinrichtung (10c, 11c, 12c, 13c) zugeordnet wird, dass zusätzlich der folgende Schritt ausgeführt wird:
- Anzeigen von Informationen durch die den Anschlüssen (6, 7, 8, 9) zugeordneten Anzeigeeinrichtungen ( 10c, 11c, 12c, 13c), welche die gegenwärtige Zuweisung und/oder Nutzung der jeweiligen Anschlüsse (6, 7, 8, 9) anzeigen,
wobei die Anzeigeeinrichtungen (10c, 11c, 12c, 13c) jeweils ringförmig um die zugeordneten Anschlüsse (6, 7, 8, 9) ausgebildet sind.

5. Messverfahren nach Anspruch 4,
**dadurch gekennzeichnet,**
**dass** die Informationen von den Anzeigeeinrichtungen (10c, 11c, 12c, 13c) durch farbliche Codierung und/oder durch Muster angezeigt werden.

## Claims

1. Measuring instrument with a control device (3), at least two connections (6, 7, 8, 9), at least two measuring channels,
wherein the control device (3) allocates connections (6, 7, 8, 9) to the measuring channels and connects the measuring channels internally at least logically with these connections (6, 7, 8, 9),
**characterised in that**
the measuring instrument also exhibits at least two display devices (10c, 11c, 12c, 13c),
**in that** each connection (6, 7, 8, 9) is allocated just one display device (10c, 11c, 12c, 13c),
**in that** the display devices (10c, 11c, 12c, 13c) allocated to the connections (6, 7, 8, 9) display information relating to the present allocation and/or use of the respective connections (6, 7, 8, 9) and
**in that** the display devices (10c, 11c, 12c, 13c) are in each case embodied in the form of a ring around the associated connections (6, 7, 8, 9).

2. Measuring instrument according to claim 1,
**characterised in that**
the respective connection (6, 7, 8, 9) and the associated display device (10c, 11c, 12c, 13c) are located in direct spatial proximity.

3. Measuring instrument according to one of claims 1 to 2,
**characterised in that** the display devices (10c, 11c, 12c, 13c) display information by colour coding and/or by patterns.

4. Measuring method using a measuring instrument with at least two connections (6, 7, 8, 9) and at least two measuring channels,
wherein the following steps are carried out:
- allocation of connections to measuring channels;
- internal at least logical connection of the connections and the allocated measuring channels,
**characterised in that**
the measuring instrument also has at least two display devices (10c, 11c, 12c, 13c), **in that** each connection (6, 7, 8, 9) is allocated just one display device (10c, 11c, 12c, 13c),
and **in that** in addition the following step is carried out:
- display of information by the display devices (10c, 11c, 12c, 13c) which are allocated to the connections (6, 7, 8, 9) and display the present allocation and/or use of the respective connections (6, 7, 8, 9),
wherein the display devices (10c, 11c, 12c, 13c) are in each case embodied in the form of a ring around the associated connections (6, 7, 8, 9).

5. Measuring method according to claim 4,
**characterised in that**
the information is displayed by the display devices (10c, 11c, 12c, 13c) by colour coding and/or by patterns.

## Revendications

1. Appareil de mesure comportant un dispositif de commande (3), au moins deux raccords (6, 7, 8, 9), au moins deux canaux de mesure,
dans lequel le dispositif de commande (3) alloue les raccords (6, 7, 8, 9) aux canaux de mesure et relie les canaux de mesure à ces raccords (6, 7, 8, 9) de manière interne au moins logiquement,
**caractérisé en ce que**
l'appareil de mesure présente en outre au moins deux dispositifs d'affichage (10c, 11c, 12c, 13c),
**en ce qu'**à chaque raccord (6, 7, 8, 9) est associé précisément un dispositif d'affichage (10c, 11c, 12c, 13c),
**en ce que** les dispositifs d'affichage (10c, 11c, 12c, 13c) associés aux raccords (6, 7, 8, 9) affichent des informations concernant l'allocation actuelle et/ou l'utilisation des raccords respectifs (6, 7, 8, 9) et
**en ce que** les dispositifs d'affichage (10c, 11c, 12c, 13c) sont réalisés respectivement sous la forme d'anneau autour des raccords associés (6, 7, 8, 9).

2. Appareil de mesure selon la revendication 1, **caractérisé en ce que**
le raccord respectif (6, 7, 8, 9) et le dispositif d'affichage associé (10c, 11c, 12c, 13c) se trouvent à proximité immédiate.

3. Appareil de mesure selon l'une des revendications 1 à 2, **caractérisé en ce que**
les dispositifs d'affichage (10c, 11c, 12c, 13c) affichent des informations par code de couleur et/ou par modèle.

4. Procédé de mesure utilisant un appareil de mesure comportant au moins deux raccords (6, 7, 8, 9) et au moins deux canaux de mesure,
dans lequel les étapes suivantes sont effectuées:
- l'allocation des raccords aux canaux de mesure;
- la liaison interne au moins logique des raccords et des canaux de mesure associés,
**caractérisé en ce que**
l'appareil de mesure dispose en outre d'au moins deux dispositifs d'affichage (10c, 11c, 12c, 13c),
**en ce qu'**à chaque raccord (6, 7, 8, 9) est associé précisément un dispositif d'affichage (10c, 11c, 12c, 13c),
**en ce qu'**en plus l'étape suivante est réalisée :
- l'affichage des informations par les dispositifs d'affichage (10c, 11c, 12c, 13c) associés aux raccords (6, 7, 8, 9), qui affichent l'allocation actuelle et/ou l'utilisation des raccords respectifs (6, 7, 8, 9), dans lequel les dispositifs d'affichage (10c, 11c, 12c, 13c) sont réalisés respectivement sous la forme d'anneau autour des raccords associés (6, 7, 8, 9).

5. Procédé de mesure selon la revendication 4, **caractérisé en ce que**
les informations sont affichées par les dispositifs d'affichage (10c, 11c, 12c, 13c) par codes de couleur et/ou par modèle.
